# EUROPÄISCHE PATENTANMELDUNG

(11) **EP 2 213 972 A1**
(43) Veröffentlichungstag der Anmeldung: **04.08.2010**
(21) Anmeldenummer: 09015180.4
(22) Anmeldetag: 08.12.2009
(51) Int. Cl.: F28F 3/12, F28F 3/04, G06F 1/20, H05K 7/20

(54) **Kühleinrichtung mit einem Rippenkühlkörper**

(30) Priorität: 23.01.2009 DE 102009005879
(71) Anmelder: SEMIKRON Elektronik GmbH & Co. KG, 90431 Nürnberg (DE)
(72) Erfinder: Backhaus, Klaus, Dr., 90768 Fürth (DE); Hager, Ludwig, 90491 Nürnberg (DE)

(57) **Zusammenfassung**

Es wird eine Kühleinrichtung (10) mit einem Rippenkühlkörper (12) beschrieben, der eine Basis (16) und von der Basis in die gleiche Richtung weg stehende und voneinander durch Spalträume (22) beabstandete Kühlrippen (18) aufweist. Um eine optimale Kühlwirkung zu erzielen, ist der Rippenkühlkörper (12) mit einem Strömungsmittel-Umlenkkörper (14) kombiniert, der Fingerrippen (20) aufweist, die in die Spalträume (22) zwischen den Kühlrippen (18) hinein stehen, so dass zwischen dem Rippenkühlkörper (12) und dem Strömungsmittel-Umlenkkörper (14) ein Strömungskanal (24) gebildet ist, der für ein die Kühlrippen (18) und die Fingerrippen (20) quer umströmendes Kühlmedium vorgesehen ist.

## Beschreibung

Die Erfindung betrifft eine Kühleinrichtung mit einem Rippenkühlkörper, der eine Basis und von der Basis in die gleiche Richtung weg stehende und voneinander durch Spalträume beabstandete Kühlrippen aufweist.

Derartige Kühleinrichtungen kommen beispielsweise bei elektronischen Leistungshalbleitermodulen zur Anwendung, um die Verlustleistung von den elektronischen Leistungshalbleiter-Bauelementen der Module abzuführen.

Die Rippenkühlkörper der Kühleinrichtungen bestehen üblicherweise aus Strangpressprofilen oder aus Fließpressprofilen, die von einem Kühlmedium in Längsrichtung ihrer Kühlrippen durchströmt werden. Der Wärmeeintrag der Verlustwärme erfolgt üblicherweise senkrecht zu dieser Richtung, d.h. ausgehend von der Basis in Richtung zu den Kühlrippen.

Bei den bekannten Rippenkühlkörpern erwärmt sich das die Spalträume durchströmende Kühlmedium nicht gleichmäßig. In der Nähe der zu kühlenden Leistungs-Bauelemente erwärmt sich das Kühlmittel stärker als in von den Bauelementen fernen Zonen, so dass es zu einer unerwünschten Schichtenbildung des Temperaturverlaufs im Kühlmedium kommt. Diese Schichtenbildung bedeutet, dass die Erwärmung des Kühlmediums in der Nähe der Wurzelabschnitte der Kühlrippen größer als die mittlere Erwärmung des Kühlmediums ist. Daraus resultiert, dass die Kühlleistung der bekannten Kühleinrichtungen mit einem in seiner Längsrichtung durchströmtem Rippenkühlkörper Wünsche offen lässt. Bei Rippenkühlkörpern mit kleinen Rippenabständen und damit verbundener, vorteilhafter großer Wärmeübergangsoberfläche besteht das Risiko lokaler Temperaturüberhöhung infolge einer Verschmutzung und einer daraus resultierenden Verstopfung, weil am Ort dieser Verstopfung der Spaltraum zumindest teilweise blockiert wird und die Kühlwirkung dieses verstopften Spaltraumes verloren geht.

In Kenntnis dieser Gegebenheiten liegt der Erfindung die Aufgabe zugrunde, eine Kühleinrichtung der eingangs genannten Art zu schaffen, die eine deutlich verbesserte Kühlwirkung besitzt.

Diese Aufgabe wird erfindungsgemäß durch die Merkmale des Anspruches 1, d.h. dadurch gelöst, dass der Rippenkühlkörper mit einem Strömungsmittel-Umlenkkörper kombiniert ist, der Fingerrippen aufweist, die in die Spalträume zwischen den Kühlrippen des Rippenkühlkörpers hinein stehen, so dass zwischen dem Rippenkühlkörper und dem Strömungsmittel-Umlenkkörper ein Strömungskanal gebildet ist, der für ein die Kühlrippen des Rippenkühlkörpers und die Fingerrippen des Strömungsmittel-Umlenkkörpers quer umströmendes Kühlmedium vorgesehen ist.

Während bei bekannten Rippenkühlkörpern das Kühlmedium die Spalträume zwischen benachbarten Kühlrippen in Längsrichtung der Kühlrippen durchströmt, durchströmt das Kühlmedium bei der erfindungsgemäßen Kühleinrichtung den durch die Kühlrippen und die Fingerrippen bestimmten Strömungskanal quer zu den Kühl- und Fingerrippen. Dadurch wird eine Temperatur-Schichtenbildung, wie sie weiter oben erwähnt worden ist, vermieden. Außerdem wird durch die erfindungsgemäße Ausbildung die nachteilige Wirkung lokaler Kanalverschmutzungen vermieden. Die Kühlwirkung der erfindungsgemäßen Kühleinrichtung ist folglich deutlich verbessert.

Als besonders vorteilhaft hat es sich erwiesen, wenn bei der erfindungsgemäßen Kühleinrichtung der einseitig durch den Spitzenabschnitt der Fingerrippen begrenzte Querschnitt des Strömungskanals im Vergleich zum restlichen Strömungskanal klein ist, weil hierdurch die Strömungsgeschwindigkeit in dem durch den Spitzenabschnitt der Fingerrippen einseitig begrenzten Abschnitt des Strömungskanales vergrößert und somit der Wärmeübergang in diesem Bereich, d.h. im Bereich der Wurzeln der Kühlrippen, erhöht und damit die Kühlwirkung verbessert ist.

Im Bereich des größten Temperaturgefälles zwischen dem Kühlmedium und der Kühleinrichtung im Bereich der Wurzeln der Kühlrippen ist die Kühlwirkung also optimiert.

Durch die Ausnutzung des gesamten Volumenstromes ergibt sich der Vorteil, dass die Erwärmung des Kühlmediums minimiert ist. Beispielsweise beträgt die Erwärmung eines Kühlmediums, das aus 50 % Wasser und 50 % Glykol besteht, bei einem Volumenstrom von z.B. 20 l/min und einer abzuführenden Verlustleistung von 3 kW nur 2,5 K.

Als vorteilhaft hat es sich bei der erfindungsgemäßen Kühleinrichtung erwiesen, wenn die Kühlrippen des Rippenkühlkörpers ein Querschnitts-Profil aufweisen, das sich von der Basis des Rippenkühlkörpers zur Spitze der Kühlrippen hin verjüngt. Die Fingerrippen des Strömungsmittel-Umlenkkörpers können ein Querschnitts-Profil mit mindestens annähernd konstanter Wanddicke aufweisen.

Erfindungsgemäß kann der Strömungsmittel-Umlenkkörper an einer Seite mit einem Einströmkanal und an der gegenüberliegenden anderen Seite mit einem Ausströmkanal für das Kühlmedium ausgebildet sein. Desgleichen ist es möglich, dass der Strömungsmittel-Umlenkkörper an seinen beiden einander gegenüberliegen den Seiten jeweils einen Einströmkanal und in einem mittleren Bereich einen Ausströmkanal aufweist.

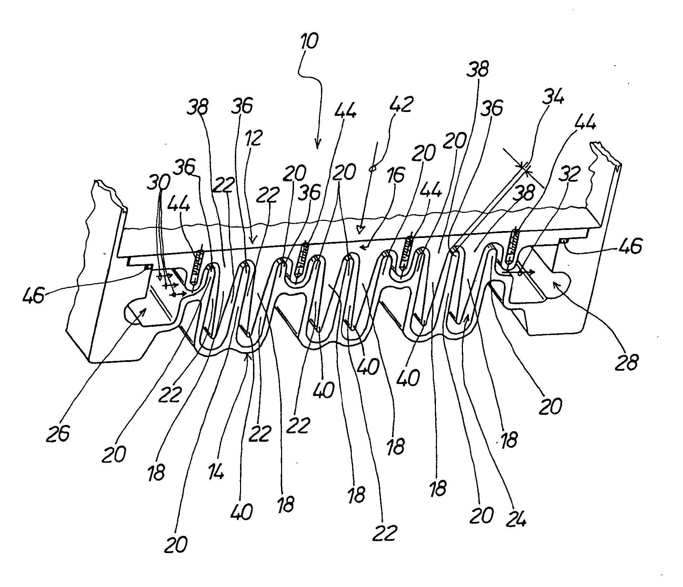

Weitere Einzelheiten, Merkmale und Vorteile ergeben sich aus der nachfolgenden Beschreibung eines in der Zeichnung dargestellten Ausführungsbeispieles der erfindungsgemäßen Kühleinrichtung in einer abschnittweisen perspektivischen Ansicht.

Die Figur zeigt eine Ausbildung der Kühleinrichtung 10 mit einem Rippenkühlkörper 12 und mit einem Strömungsmittel-Umlenkkörper 14. Der Rippenkühlkörper 12 weist eine Basis 16 und Kühlrippen 18 auf, die von der Basis 16 materialeinstückig, voneinander beabstandet in die gleiche Richtung wegstehen.

Der Strömungsmittel-Umlenkkörper 14 weist Fingerrippen 20 auf, die in die Spalträume 22, die zwischen den Kühlrippen 18 ausgebildet sind, hinein stehen. Zwischen dem Rippenkühlkörper 12 und dem Strömungsmittel-Umlenkkörper 14 wird somit ein Strömungskanal 24 gebildet, der für ein die Kühlrippen 18 des Rippenkühlkörpers 12 und die Fingerrippen 20 des Strömungsmittel-Umlenkkörpers 14 quer umströmendes Kühlmedium vorgesehen ist. Zu diesem Zwecke ist der Strömungsmittel-Umlenkkörper 14 an einer Seite mit einem Einströmkanal 26 für ein Kühlmedium und an der gegenüberliegenden anderen Seite mit einem Ausströmkanal 28 für das Kühlmedium ausgebildet. Die Einströmrichtung des Kühlmediums in den Strömungskanal 24 zwischen dem Rippenkühlkörper 12 und dem Strömungsmittel-Umlenkkörper 14 ist auf der linken Seite der Zeichnung durch die Pfeile 30 angedeutet und die Ausströmrichtung des Kühlmediums ist auf der rechten Seite durch den Pfeil 32 angedeutet.

Der durch einen Doppelpfeil 34 verdeutlichte Querschnitt des Strömungskanales 24 ist im Bereich des Spitzenabschnittes 36 der Fingerrippen 20 im Vergleich zum Querschnitt des übrigen Strömungskanales 24 klein, so dass hier die Strömungsgeschwindigkeit des den Strömungskanal 24 quer durchströmenden Kühlmediums groß ist. Hierdurch ergibt sich im Bereich der Wurzeln 38 der Kühlrippen 18 eine gute Wärmeabfuhr und somit eine optimale Kühlwirkung der Kühleinrichtung 10.

Um den Querschnitt des Strömungskanales zwischen benachbarten Spitzenabschnitten 36 der Fingerrippen 20 zu vergrößern, weisen die Kühlrippen 18 des Rippenkühlkörpers 12 ein Querschnitts-Profil auf, das sich von der Basis 16, d.h. von der Wurzel 38 zur Spitze 40 der jeweiligen Fingerrippe 20 hin verjüngt. Die Fingerrippen 20 des Strömungsmittel-Umlenkkörpers 14 weisen z.B. ein Querschnitts-Profil mit einer mindestens annähernd konstanten Wanddicke auf.

Der Wärmeeintrag der Verlustwärme in die Kühleinrichtung 10 eines nicht gezeichneten elektronischen Leistungsmoduls erfolgt in der durch den Pfeil 42 angedeuteten Richtung. Die Befestigung des nicht gezeichneten Leistungsmoduls erfolgt z.B. mit Hilfe von Befestigungsschrauben, die in Gewindesacklöcher 44 einschraubbar sind, die im Rippenkühlkörper 12 ausgebildet sind.

Die Kühlrippen 18 des Rippenkühlkörpers 12 sind zweckmäßigerweise den (nicht gezeichneten) Leistungschips zugeordnet, d.h. dort vorgesehen, wo sich die nicht gezeichneten Leistungschips des Leistungshalbleitermoduls befinden, um eine effiziente Kühlung zu bewirken.

Der Strömungsmittel-Umlenkkörper 14 ist mit dem Rippenkühlkörper 12 mittels eines Dichtungselementes 46 abdichtend verbunden.

### Bezugsziffernliste:

- 10: Kühleinrichtung
- 12: Rippenkühlkörper (von 10)
- 14: Strömungsmittel-Umlenkkörper (von 10)
- 16: Basis (von 12)
- 18: Kühlrippen (von 12 an 16)
- 20: Fingerrippen (von 14)
- 22: Spalträume (zwischen 18 und 18)
- 24: Strömungskanal (zwischen 12 und 14)
- 26: Einströmkanal (von 10)
- 28: Ausströmkanal (von 10)
- 30: Pfeile / Einströmrichtung des Kühlmediums
- 32: Pfeil / Ausströmrichtung des Kühlmediums
- 34: Doppelpfeil / Querschnitt (von 24 bei 36)
- 36: Spitzenabschnitt (von 20)
- 38: Wurzel (von 18)
- 40: Spitze (von 18)
- 42: Pfeil / Wärmeeintrag (in 10)
- 44: Gewindesacklöcher (in 12)
- 46: Dichtungselement (zwischen 12 und 14)

## Patentansprüche

1. Kühleinrichtung mit einem Rippenkühlkörper (12), der eine Basis (16) und von der Basis in die gleiche Richtung weg stehende und voneinander durch Spalträume (22) beabstandete Kühlrippen (18) aufweist,
**dadurch gekennzeichnet,**
**dass** der Rippenkühlkörper (12) mit einem Strömungsmittel-Umlenkkörper (14) kombiniert ist, der Fingerrippen (20) aufweist, die in die Spalträume (22) zwischen den Kühlrippen (18) des Rippenkühlkörpers (12) hinein stehen, so dass zwischen dem Rippenkühlkörper (12) und dem Strömungsmittel-Umlenkkörper (14) ein Strömungskanal (24) gebildet ist, der für ein die Kühlrippen (18) des Rippenkühlkörpers (12) und die Fingerrippen (20) des Strömungsmittel-Umlenkkörpers (14) quer umströmendes Kühlmedium vorgesehen ist.

2. Kühleinrichtung nach Anspruch 1,
**dadurch gekennzeichnet,**
**dass** der einseitig durch den Spitzenabschnitt (36) der Fingerrippen (20) begrenzte Querschnitt (34) des Strömungskanales (24) im Vergleich zum restlichen Strömungskanal (24) klein ist.

3. Kühleinrichtung nach Anspruch 1,
**dadurch gekennzeichnet,**
**dass** die Kühlrippen (18) des Rippenkühlkörpers (12) ein Querschnitts-Profil aufweisen, das sich von der Basis (16) des Rippenkühlkörpers (12) zur Spitze (40) der Kühlrippen (18) hin verjüngt.

4. Kühleinrichtung nach Anspruch 1,
**dadurch gekennzeichnet,**
**dass** die Fingerrippen (20) des Strömungsmittel-Umlenkkörpers (14) ein Querschnitts-Profil mit mindestes annähernd konstanter Wanddicke aufweisen.

5. Kühleinrichtung nach Anspruch 1,
**dadurch gekennzeichnet,**
**dass** der Strömungsmittel-Umlenkkörper (14) an einer Seite einen Einströmkanal (26) und an der gegenüberliegenden anderen Seite einen Ausströmkanal (28) für das Kühlmedium aufweist.

6. Kühleinrichtung nach Anspruch 1,
**dadurch gekennzeichnet,**
**dass** der Strömungsmittel-Umlenkkörper (14) an seinen beiden einander gegenüberliegenden Seiten jeweils einen Einströmkanal (26) und in einem mittleren Bereich einen Ausströmkanal (28) aufweist.

7. Verwendung der Kühleinrichtung (10) nach einem der Ansprüche 1 bis 6 für ein Leistungsmodul.
